(19) Europäisches Patentamt
European Patent Office
Office européen des brevets

(11) Publication number : **0 512 692 A1**

(12) **EUROPEAN PATENT APPLICATION**

(21) Application number : **92303219.7**

(22) Date of filing : **10.04.92**

(51) Int. Cl.$^5$ : **G03F 7/075,** G03F 7/038, C08G 73/10

(30) Priority : **11.04.91 JP 106745/91**

(43) Date of publication of application : **11.11.92 Bulletin 92/46**

(84) Designated Contracting States : **DE FR GB**

(71) Applicant : **Shin-Etsu Chemical Co., Ltd.**
**6-1, Otemachi 2-chome**
**Chiyoda-ku Tokyo 100 (JP)**

(72) Inventor : **Okinoshima, Hiroshige**
**No. 19-1, Isobe 3-chome**
**Annaka-shi, Gunma-ken (JP)**
Inventor : **Kato, Hideto**
**No. 179-5, Kaminamie-machi**
**Takasaki-shi, Gunma-ken (JP)**
Inventor : **Terasawa, Yutaka**
**A-104, Sakuragaoka Ryo**
**Annaka-shi, Gunma-ken (JP)**

(74) Representative : **Stoner, Gerard Patrick et al**
**Mewburn Ellis 2 Cursitor Street**
**London EC4A 1BQ (GB)**

(54) **Photosensitive materials and process for making them.**

(57) A photosensitive material which comprises a photosensitive polyimide precursor having recurring units of the following general formula (1)

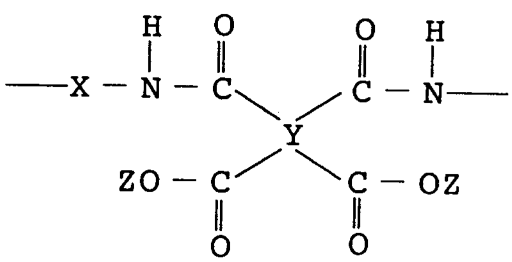

....(1)

wherein X represents a divalent organic group, Y represents a tetravalent organic group, and each Z represents a hydrogen atom or $SiR^1_nR^2_{(3-n)}$ provided that at least one of Z's is $SiR^1_nR^2_{(3-n)}$, in which $R^1$ is a group having a functional group capable of dimerization or polymerization by application of light or a radiation, $R^2$ is a hydrogen atom or a monovalent organic group having from 1 to 10 carbon atoms, and n is an integer of from 1 to 3. The photosensitive material is able to yield a heat-resistant cured film useful as an insulating or alignment film for semiconductor devices, liquid crystal display devices or multilayered printed boards.

EP 0 512 692 A1

This invention relates to photosensitive materials, such as are useful for e.g. an insulating film for semiconductor elements, an alignment film for liquid crystal display devices, and an insulating film for multi-layered printed boards. The invention also relates to processes for preparing and using them.

A number of heat-resistant photosensitive materials have been proposed including materials composed of polyamic acids and bichromates (Japanese Laid-open Patent Application No. 49-17374), materials composed of polyamic acids wherein a photosensitive group is introduced into the carboxyl group thereof through ester bond (Japanese Laid-open Patent Application Nos. 49-115541 and 60-37550), materials composed of polyamic acids and amine compounds having photosensitive groups (Japanese Laid-open Patent Application No. 54-145794), and materials obtained by reaction between polyamic acids and epoxy compounds having a photosensitive group (Japanese Laid-open Patent Application No. 55-45746). However, these materials have the problems such as incorporation of ionic impurities and lowering of stabilities in photosensitivity and storage.

With the aim of reducing the above problems, Japanese Laid-open Patent Application No. 62-275129 has proposed photosensitive polyimide precursors which are obtained by reaction between tetracarboxylic dianhydride and silylated diamines. Since halosilanes are used for the preparation of the silylated diamine during the preparation process of the polyimide precursor, ionic impurities are inevitably incorporated.

The general problem addressed herein is to provide novel photosensitive materials and methods of making and using them. In particular, it would be preferable to provide a heat-resistant photosensitive material which overcomes at least to some extent the problems involved in the prior art counterparts.

It is a particularly preferred aspect to provide a heat-resistant photosensitive material which is substantially free of any ionic impurities, by using a reaction by which chlorosilane or other chlorine ions or alkaline ions are not secondarily produced, thus giving good storage stability.

As a result of intensive studies, the present inventors have found that when a polyimide precursor having recurring units of the general formula (2) indicated hereinafter and a hydrosilane of the general formula (3) indicated hereinafter are mixed for reaction at a ratio by weight between the hydrosilane and the carboxyl groups of the polyimide precursor of 0.1 : 1 to 1 : 1, they can obtain a photosensitive polyimide precursor having recurring units of the general formula (1) indicated hereinafter. Examples of photosensitive materials comprising the thus obtained photosensitive polyimide precursors were found to be substantially free of ionic impurities and with good storage stability. When these photosensitive materials were irradiated, the resultant polyimide films had good electric and mechanical characteristics and a good heat resistance.

According to one aspect of the invention, therefore, there is provided a photosensitive material which comprises a photosensitive polyimide precursor having recurring units of the following general formula (1)

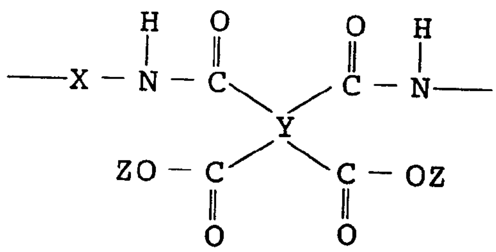

....(1)

wherein X represents a divalent organic group, Y represents a tetravalent organic group, and each Z represents a hydrogen atom or $SiR^1_nR^2_{(3-n)}$ provided that at least part of Z's is $SiR^1_nR^2_{(3-n)}$, in which $R^1$ is a group having a functional group capable of dimerization or polymerization by application of light or a radiation, $R^2$ is a hydrogen atom or a monovalent organic group having from 1 to 10 carbon atoms, and n is an integer of from 1 to 3.

According to another aspect of the invention, there is also provided a process for preparing a photosensitive material which comprises reacting a polyimide precursor having recurring units of the following general formula (2) and a hydrosilane compound of the following general formula (3) which are mixed at a ratio by weight between the compound of the formula (3) and the carboxyl groups of the formula (2) of 0.1 : 1 to 1 : 1.

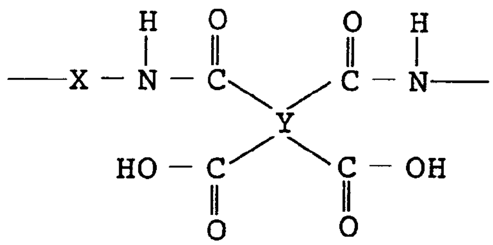

.... (2)

$HSiR^1_nR^2_{(3-n)}$ (3)

wherein X, Y and n have, respectively, the same meanings as defined above. Also, a product obtainable thereby.

Further explanations now follow, with statements of preferred features and of advantages which may be achieved.

The photosensitive material of the invention should comprise a photosensitive polyimide precursor having recurring units of the following general formula (1)

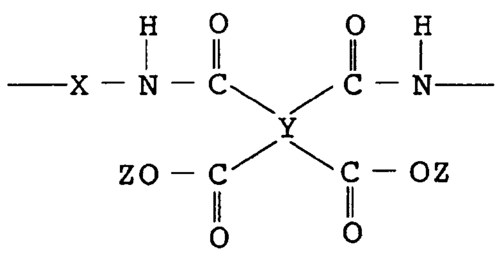

.... (1)

wherein X represents a divalent organic group, Y represents a tetravalent organic group, and each Z represents a hydrogen atom or $SiR^1_nR^2_{(3-n)}$ provided that at least part of Z's is $SiR^1_nR^2_{(3-n)}$, in which $R^1$ is a group having a functional group capable of dimerization or polymerization by application of light or a radiation, $R^2$ is a hydrogen atom or a monovalent organic group having from 1 to 10 carbon atoms, and n is an integer of from 1 to 3.

Alternatively stated, the polyimide precursor is a polyimide precursor obtainable by reaction through the carboxyl groups of a polyimide precursor having recurring units of the following general formula (2) and the hydrogen atom of a hydrosilane of the following general formula (3)

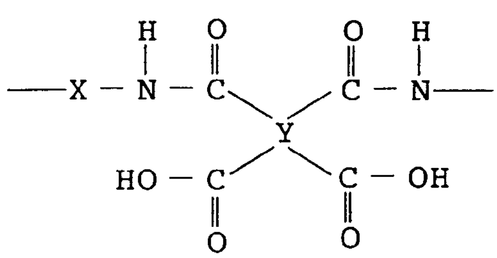

.... (2)

$HSiR^1_nR^2_{(3-n)}$ (3)

wherein X, Y and n have, respectively, the same meanings as defined above. It will be noted that X, Y, Z and n which will appear hereinafter have, respectively, the same meanings as defined hereinabove unless otherwise indicated and will not be particularly defined hereinafter.

A polyimide precursor having recurring units, of the above formula ( 2 ), may be prepared from a tetracarboxylic dianhydride of the following general formula (4) and a diamine of the formula, $H_2N - X - NH_2$.

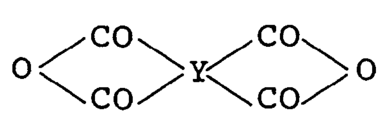

.... (4)

The tetracarboxylic dianhydrides are those corresponding to the substituent, Y, i.e. a tetravalent organic group, of the formula (1) or (2). Examples are shown below but should not be construed as limitation and the substituent, Y, may be those which are indicated below and may be used singly or in combination.

Examples of the dianhydrides include pyromellitic dianhydride when Y is

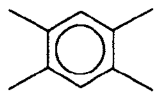

,

benzophenonetetracarboxylic dianhydride when Y

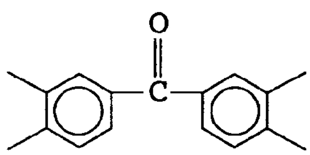

,

3,3′,4,4′-biphenyltetracarboxylic dianhydride when Y is

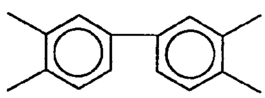

,

2,2-bis(3,4′-benzenedicarboxylic anhydride) perfluoropropane when Y is

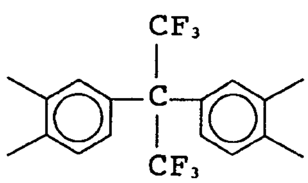

,

(3,4′-dicarboxyphenyl)dimethylsilane dianhydride when Y is

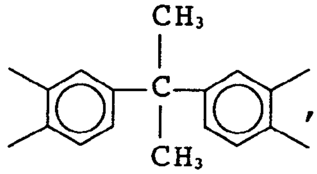

,

and 1,3-bis(3,4-di-carboxyphenyl)-1,1,3,3-tetramethyldisiloxane dianydride when Y is

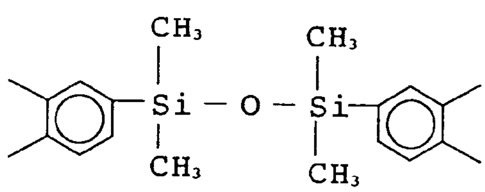

.

The diamines, $H_2N$ - X - $NH_2$, are those which has a diamine residue corresponding to the substituent, X, (divalent organic group) of the formula (1) or (2).

Examples of the diamine include aromatic ring-containing diamines having from 6 to 20 carbon atoms such

as p-phenylenediamine, m-phenylenediamine, 4,4′-diaminodiphenylmethane, 4,4′-diaminodiphenyl ether, 2,2′-bis(4-aminophenyl)propane, 4,4′-diaminodiphenyl-sulfone, 4,4′-diaminodiphenylsulfide, 1,4-bis(3-aminophenoxy)benzene, 1,4-bis(4-aminophenoxy)benzene, 1,4-bis(m-amino-phenylsulfonyl)benzene, 1,4-(p-aminophenyl-sulfonyl)benzene, 1,4-bis(m-aminophenylthio ether)benzene, 1,4-bis(p-aminophenylthio ether)benzene, 2,2-bis(4-(4-aminophenoxy)-phenyl]propane, 2,2-bis[3-methyl-4-(4-aminophenoxy)phenyl)propane, 2,2-bis[3-methyl-4-(4-aminophenoxy)phenyl]propane, 2,2-bis[3-chloro-4-(4-aminophenoxy)-phenyl]propane, 1,1-bis(4-(4-aminophenoxy)-phenyl]ethane, 1,1-bis[3-methyl-4-(4-aminophenoxy)phenyl]ethane, 1,1- bis[3-chloro-4-(4-aminophenoxy)phenyl]ethane, 2,2-bis[3,5-dimethyl-4-(4-aminophenoxy)-phenyl]ethane, bis(4-(4-aminophenoxy)-phenyl]methane, bis[3-methyl-4-(4-aminophenoxy)phenyl]methane, bis[3-chloro-4-(4-aminophenoxy)phenyl]methane, bis[3,5-dimethyl-4-(4-aminophenoxy)phenyl]methane, bis(4-(4-aminophenoxy)phenyl]sulfone, 2,2-bis(4-(4-aminophenoxy)phenyl]perfluoropropane, and the like. In addition, diamines or polysilicon-diamines which have nuclear substituents such as an amino group and an amido group as shown below may be used.

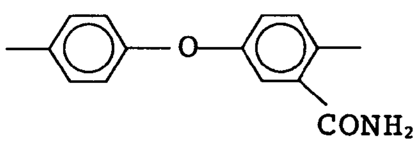 , 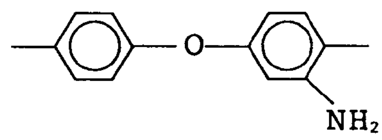

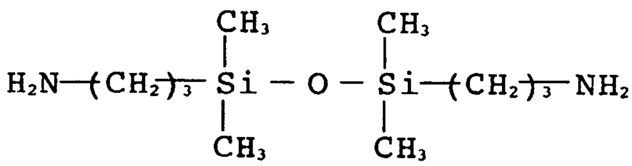 ,

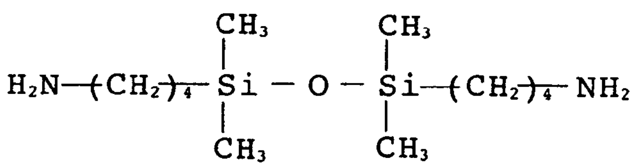 ,

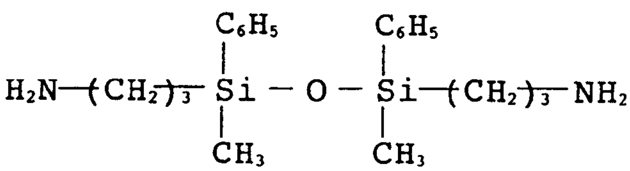 ,

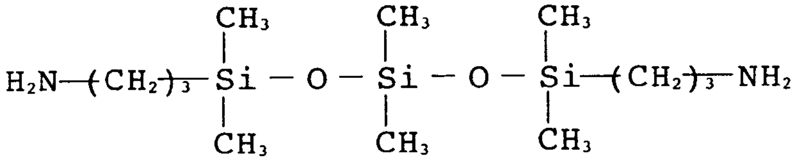 ,

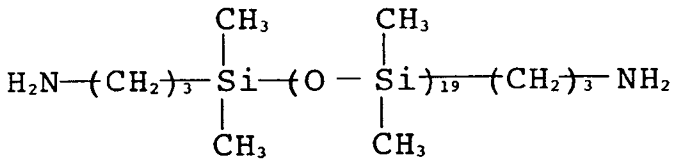 ,

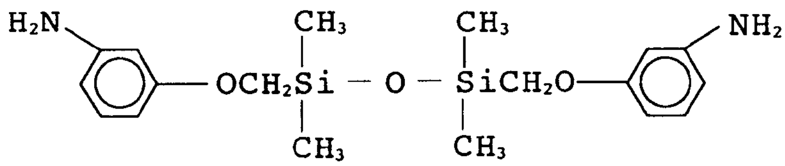

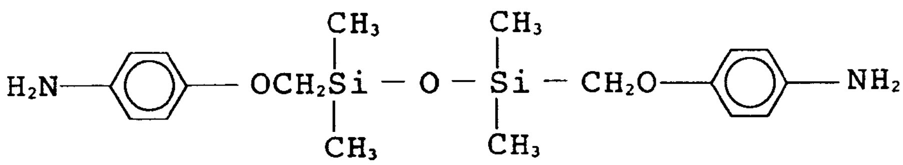 ,

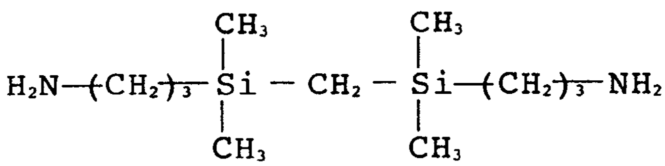 ,

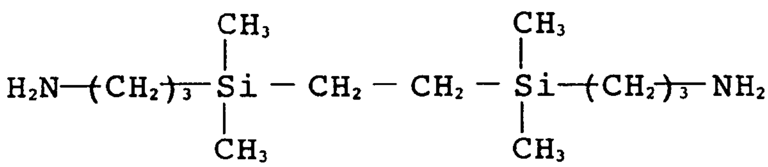 ,

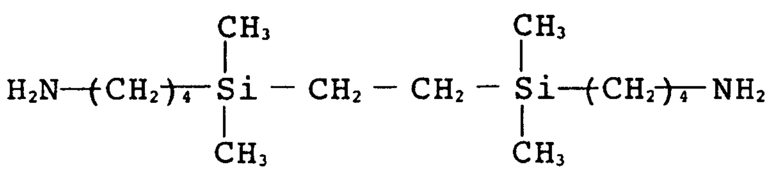 ,

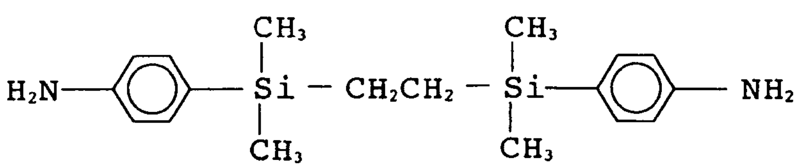 ,

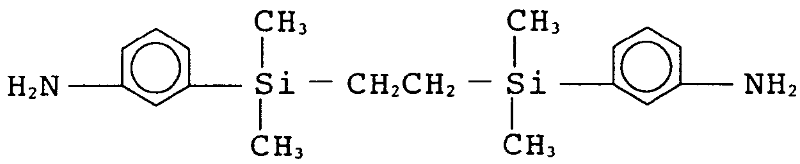 ,

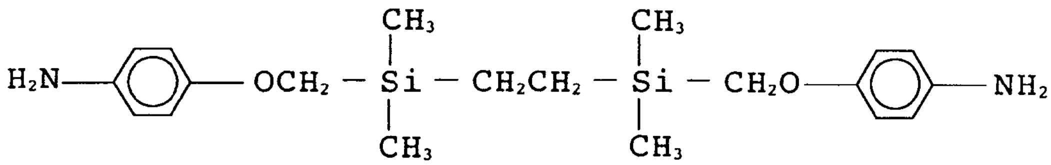 ,

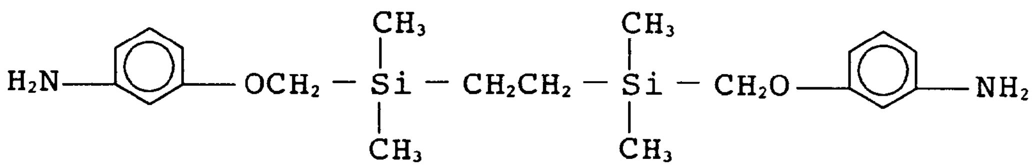 ,

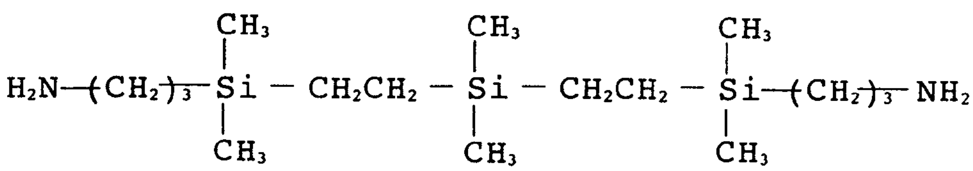 ,

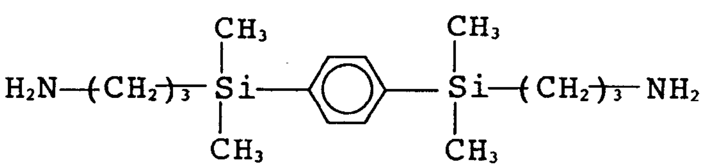

These examples are not shown as limitative. X may be one or more of the diamine residues.

On the other hand, at least one of the substituents, $R^1$, of the hydrosilane of the formula (3) which is reacted with the polyimide precursor of the formula (2) should have a functional group capable of dimerization or polymerization by application of light or other radiation. By the reaction between the hydrosilane of the formula (3) having $R^1$ and the polyimide precursor of the formula (2), there can be obtained a photosensitive polyimide precursor having recurring units of the formula (1) which have the functional group, $R^1$, capable of dimerization or polymerization by application of light or a radiation. In the case, specific examples of $R^1$ include those indicated below.

$CH_2{=}CH-$ , $CH_2{=}CH-CH_2-$ , 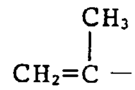 , 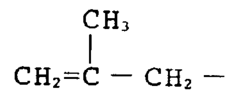 ,

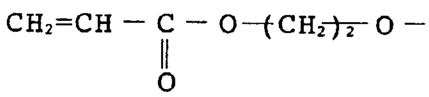 , 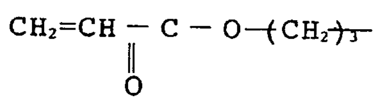 ,

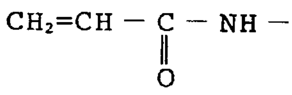 , 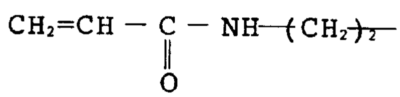 ,

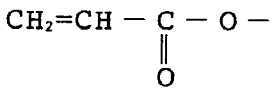 , 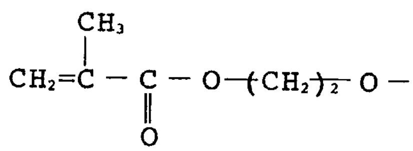 ,

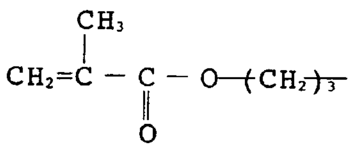 , 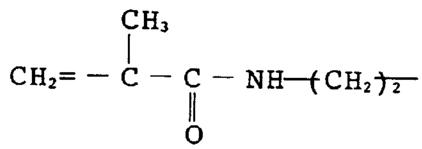 ,

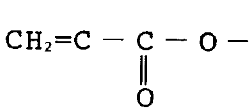 , 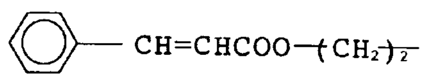 ,

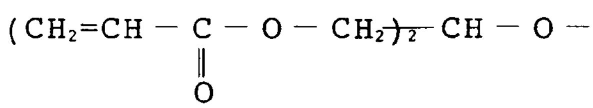 ,

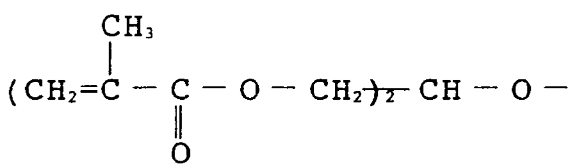 ,

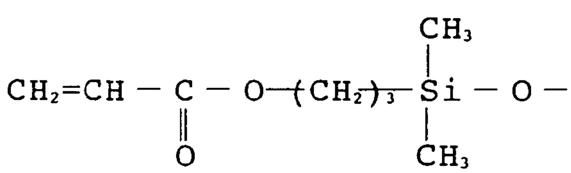 ,

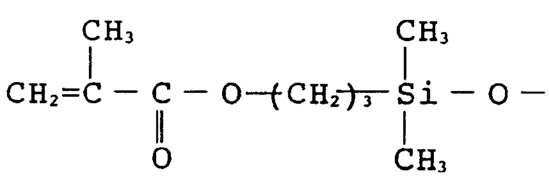

In the formula (1) or (2), $R^2$ represents a hydrogen atom or a monovalent organic group having 1 to 10 carbon atoms which is an unsubstituted hydrocarbon group such as an alkyl group e.g. a methyl group, an ethyl

group, a propyl group, a butyl group or the like, an aryl group e.g. a phenyl group, a tolyl group or the like, with or without part or all of the hydrogen atoms of the hydrocarbon group being substituted with a halogen atom, or an alkoxy or aryloxy group such as a methoxy group, an ethoxy group, a phenoxy group or the like.

A photosensitive polyimide precursor of the invention is obtainable by reaction between the polyimide precursor of the formula (2) and the hydrosilane of the formula (3) through the carboxyl groups of the polyimide precursor and the hydrogen atoms of the hydrosilane. The ratio by weight of the compound of the formula (3) and the carboxyl groups of the compound of the formula (2) is in the range of from 0.1 : 1 to 1 : 1, preferably from 0.3 : 1 to 1 : 1 in view of the photosensitivity. If the mixing ratio is less than 0.1, satisfactory photosensitivity may not always be shown. Over the ratio of 1, the storage stability may be impeded since the hydrosilane is left in the resulting compound.

The carboxylic acid groups of the polyimide precursor of the formula (2) and the hydrogen atoms of the hydrosilane are reacted for dehydrogenation by which the COOH groups of the polyimide precursor of the formula (2) is converted to $COOSiR^1_nR^2_{(3-n)}$ partially or wholly depending on the amount of the hydrosilane, thereby obtaining a reaction product having recurring units of the following structure (1′)

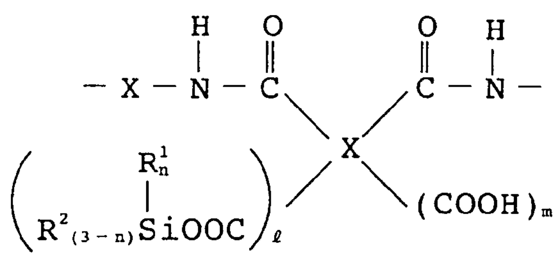

....(1′)

In the above formula, it is preferred that $\ell + m = 2$ and $0 \leqq m/\ell \leqq 9$. From the standpoint of the sensitivity of the composition, it is more preferred that $m/\ell \leqq 3$.

The reaction between the polyimide precursor and the hydrosilane should preferably be effected in organic solvents. The organic solvent is not critical with respect to the type provided that it does not react with the polyimide precursor and the hydrosilane and is capable of dissolving both compounds. Examples of such solvents include amides such as N,N-dimethylacetamide, N-methyl-2-pyrrolidone and the like, ethers such as tetrahydrofuran, 1,4-dioxane, diethylene glycol dimethyl ether, diethylene glycol diethyl ether and the like, "cellosolves®" such as methyl cellosolve, ethyl cellosolve, butyl cellosolve and the like, ketones such as acetone, methyl ethyl ketone, methyl isobutyl ketone, cyclopentanone, cyclo-hexanone and the like, and esters such as γ - butyrolactone, butyl cellosolve acetate, butyl acetate, ethyl acetate and the like. These examples are not limitative.

In the above reaction, it is preferred to use a catalytic amount of a catalyst such as a platinum compound such as chloroplatinic acid, a palladium compound or the like. The reaction conditions are not critical. The reaction is effected in the organic solvent at a temperature of from room temperature to 120°C, preferably from room temperature to 80°C, for a time of from 5 to 20 hours, preferably from 0.5 to 10 hours.

A photosensitive material is generally mainly composed of the photosensitive polyimide precursor having recurring units of the formula (1). In the precursor, the number of repetitions of the units is in the range of from 5 to 500, preferably from 10 to 200.

The photosensitive material of the invention may be used as a photosensitive resin solution composition wherein the photosensitive polyimide precursor is dissolved in an organic solvent. These organic solvents are not limitative and include, for example, amides such as N-methyl-2-pyrrolidone, N,N-dimethyl-acetamide, N,N-dimethylformamide and the like, ethers such as tetrahydrofuran, 1,4-dioxane, diethylene glycol dimethyl ether, diethylene glycol diethyl ether and the like,"cellosolves®" such as methyl cellosolve, ethyl cellosolve, butyl cellosolve and the like, ketones such as acetone, methyl ethyl ketone, methyl isobutyl ketone, cyclopentanone, cyclohexane and the like, and esters such as γ - butyrolactone, butyl cellosolve acetate, butyl acetate, ethyl acetate and the like. These solvents may be used singly or in combination. In this sense, the photosensitive imide precursor which has been obtained by the reaction between the polyimide precursor of the formula (2) and the hydrosilane of the formula (3) may be used in the form of the photosensitive polyimide precursor solution without separation from the reaction solution.

The amount of the solvent is in the range of from 30 to 98 wt%, preferably from 40 to 95 wt%, based on the total photosensitive resin solution composition.

In addition to the organic solvent, organic compounds such as toluene, xylene and the like may be added in amounts not impeding the solubility of the photosensitive polyimide precursor in order to improve the coating

properties.

Moreover, the photosensitive material of the invention may further comprise photopolymerization initiators. Examples of the photo-polymerization initiators include Micheler's ketones, benzoin, 2-methylbenzoin, benzoin methyl ether, benzoin ethyl ether, benzoin isopropyl ether, benzoin butyl ether, 2-t-butylanthraquinone, 1,2-benzo-9,10-anthraquinone, anthraquinone, methylanthraquinone, 4,4′-bis(diethylamino)benzophenone, acetophenone, benzophenone, thioxanthone, 1,5-acenaphthene, 2,2-dimethoxy-2-phenyl-acetophenone, 1-hydroxycyclohexyl phenyl ketone, 2-methyl- [4-(methylthio)phenyl]2-morpholino-1-propane, diacetyl, benzyl, benzyl dimethyl ketal, benzyl diethyl ketal, diphenyl disulfide, anthracene, 2-nitrofluorene, dibenzalacetone, 1-nitropyrene, 1,8-dinitropyrene, 1,2-naphthoquinone, 1,4-naphthoquinone, 1,2-benzanthraquinone, 2,6-di(p-azidobenzal)-4-methylcyclohexanone, 2,6-di(p-azidobenzal)cyclohexanone, 4,4′-diazidochalcone, 4,4′-diazidobenzalacetone, 4,4′-diazidostilbene, 4,4′-diazidobenzphenone, 4,4′-diazidodiphenylmethane, 4,4′-diazidophenylamine, and the like. These compounds may be used singly or in combination. The photo-polymerization initiator may be used in an amount of from 0.1 to 20 wt%, preferably from 0.1 to 10 wt%, based on the photosensitive polyimide precursor.

The photosensitive material of the invention may further comprise additional compounds having photopolymerizable functional group or groups in order to improve the photosensitivity. Examples of such compounds include butyl acrylate, cyclohexyl acrylate, dimethylamino-ethyl methacrylate, benzyl acrylate, carbitol acrylate, 2-ethylhexyl acrylate, 2-ethylhexyl methacrylate, lauryl methacrylate, 2-hydroxy-ethyl acrylate, 2-hydroxypropyl methacrylate, glycidyl methacrylate, N-methylolacrylamide, N-diacetonacrylamide, N,N′-methylenebisacryl-amide, N-vinylpyrrolidone, ethylene glycol diacrylate, diethyl glycol diacrylate, triethylene glycol diacrylate, butylene glycol diacrylate, butylene glycol dimethacrylate, neopentyl glycol diacrylate, neopentylglycol dimethacrylate, 1,4-butanediol diacrylate, 1,6-hexanediol diacrylate, 1,6-hexanediol dimethacrylate, pentaerythritol diacrylate, pentaerythritol triacrylate, trimethylolpropane triacrylate, trimethylolpropane trimethacrylate and the like.

The amount of the compound is not critical but is in a range not impeding the properties of the photosensitive material of the invention.

The photosensitive material of the invention in the form of a solution may be applied onto a substrate such as silicon wafers, metallic sheets or glass sheets by known techniques such as spin coating, dipping, printing and the like. The resultant film is pre-baked at a temperature of from 30 to 150°C for several minutes to several tens minutes by heating means such as an electric furnace or a hot plate, thereby removing almost all of the solvent from the film. A negative mask is then placed on the film, followed by irradiation with light rays such as visible light, UV ray and the like, or a radiation, preferably with a UV ray. Thereafter, unexposed portions are removed by dissolution in a developer to obtain a relief pattern. The developer may be those compounds indicated as the organic solvent hereinbefore. Alternatively, mixed solutions of such solvents and lower alcohols, e.g. methanol, ethanol and propanol, which are poor solvents for the photosensitive polyimide precursor of the invention. In this case, the relief pattern may be rinsed with the poor solvent and dried at a temperature not higher than 150°C, if desired, to stabilize the relief pattern.

Since the polymer of the relief pattern formed by the development is in the form of the precursor, it is heated at a temperature of from 200 to 500°C, preferably from 300 to 400°C, for several minutes to several hours by heating means indicated hereinbefore, thereby obtaining a patternized poly(amide)imide film.

We found that polyimide film pattern obtained from photosensitive materials embodying the invention had excellent heat resistance and good electric and mechanical characteristics.

The photosensitive materials may be obtained substantially free of ionic impurities, with good storage stability and the ability to yield a polyimide film, by application of light or a radiation, also with a good heat resistance and good electric and mechanical properties. Such a photosensitive material can be readily obtained,

The photosensitive material may be used to directly form a fine pattern, for example, on semiconductor elements by application of light. Thus, the photosensitive material is appropriately applied as surface protective films for semiconductor elements, such as a junction coat film, a passivation film, a buffer coat film, an $\alpha$ ray - shielding film and the like, an insulating film for semiconductor elements such as a layer insulating film; an alignment film for liquid crystal display devices, and insulating film for multi-layered printed boards.

The present invention is more particularly described by way of examples, which should not be construed as limiting the invention thereto.

Examples 1 and 2

32.2 g (0.1 mol) of 3,3′-4,4′-benzophenonetetracarboxylic dianhydride was dissolved in 200 g of N-methyl-2-pyrrolidone in a stream of nitrogen to obtain a solution. An amine solution of 19.0 g (0.095 mols) of 4,4′-diaminodiphenyl ether and 1.2 g (0.005 mols) of 1,3-bis( $\gamma$-aminopropyl)-1,1,3,3-tetra-methyldisiloxane dissolved

in 100 g of N-methyl-2-pyrrolidone was dropped in the above solution in such a way that the reaction temperature did not exceed 40°C. After completion of the dropping, the mixture was agitated for further 1 hour to obtain a solution (A) of a polyimide precursor having a viscosity of 4000 cps., with the following structure.

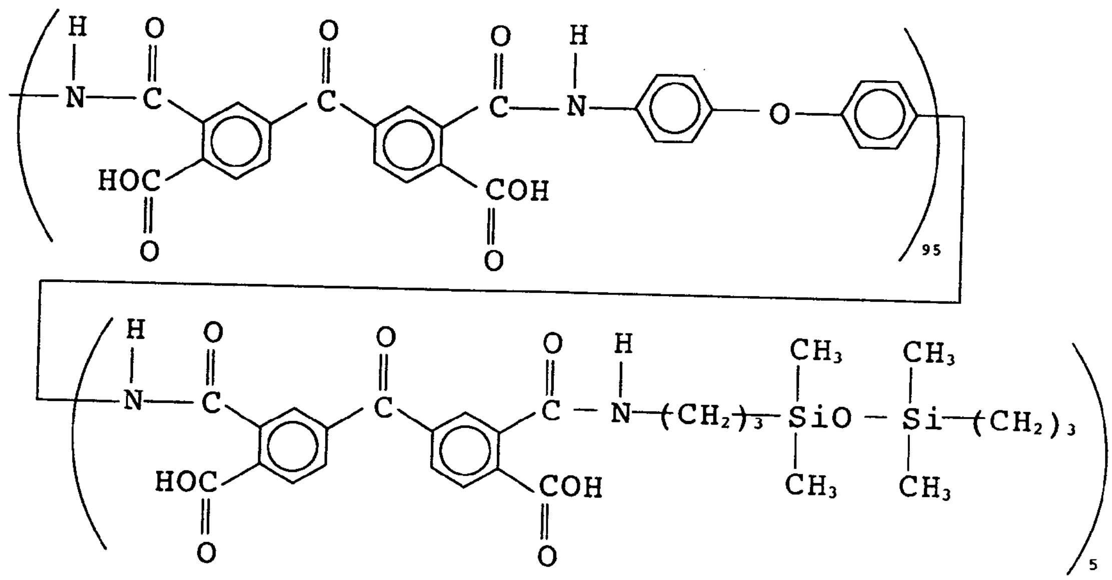

0.1 g of an octyl alcohol - modified chloroplatinic acid solution having a platinum content of 2% was added to 70 g of the polyimide precursor solution, followed by heating to 40°C and addition of 9.9 g (0.04 mols) of hydrosilane (i) of the following structural formula

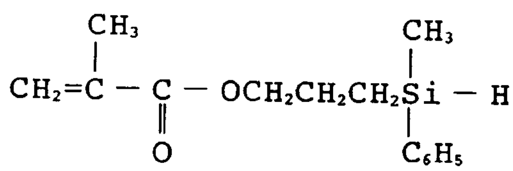

....(i)

Upon addition of the hydrosilane (i), $H_2$ generated, followed by reaction at 40°C for 4 hours, thereby obtaining an N-methyl-2-pyrrolidone solution of photosensitive polyimide precursor ( I ) with the following structure (Example 1).

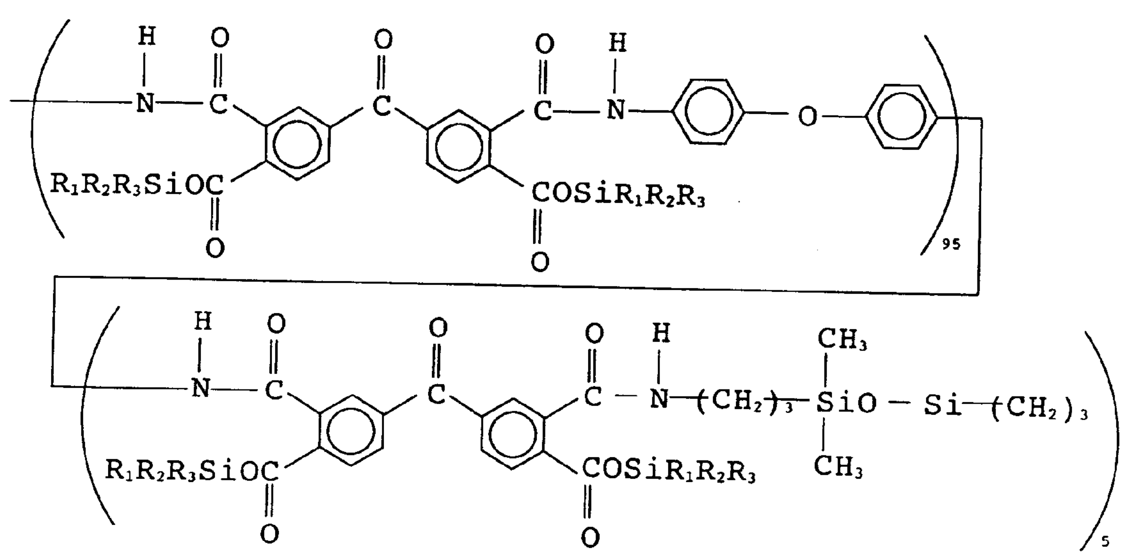

wherein $R_1$: $CH_3$, $R_2$: $C_6H_5$ and $R_3$:

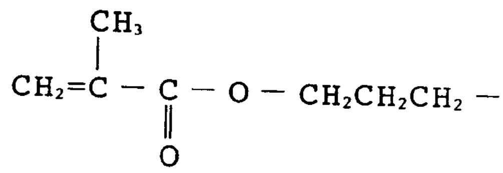

On the other hand, an octyl alcohol-modified chloroplatinic acid solution having a platinum content of 2% was added to 70 g of the polyimide precursor solution (A), followed by heating to 40°C and addition of 2.3 g (0.012 mols) of hydrosilane (ii) having the following structural formula

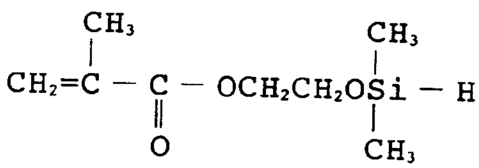

....(ii)

Generation of Hz was confirmed on the addition of the hydrosilane (ii). The mixture was further reacted at 40°C for 4 hours to obtain a N-methyl-2-pyrrolidone solution of photosensitive polyimide precursor having a similar structure as with the polyimide precursor ( II ) except that in the formula, R=

$CH_3$, $R_2$ = $CH_3$ and $R_3$ = 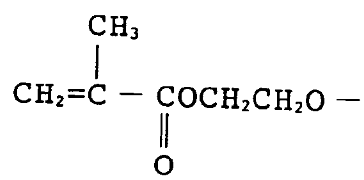

(Example 2).

3 parts by weight of Micheler's ketone (based on the polyimide precursor) was added as a sensitizer to each of the solutions of the photosensitive polyimide precursors ( I ) and ( II ) obtained in Examples 1 and 2, respectively, after which each solution was spin coated on a silicon wafer and dried at 80°C for 1 hour to obtain a 6 µm thick film. The film was exposed to light through a contact mask for 2 minutes by the use of a 500 W high pressure mercury lamp, followed by development in N-methyl-2-pyrrolidone for 2 minutes. The developed film was rinsed with isopropyl alcohol. As a result, clear relief structures were obtained both from the polyimide precursors ( I ) and ( II ). Further, the structures were each thermally treated at 350°C for 1 hour to obtain polyimide patterns.

The photosensitive polyimide precursors ( I ) and ( II ) were subjected to measurements of ionic impurities, storage stability, heat resistance of the polyimide film and adhesive to the silicon wafer according to the following procedures. The results are shown in Table 1.

Table 1

| | | Example 1 | Example 2 |
|---|---|---|---|
| Photosensitive polyimide precursor | | ( I ) | ( II ) |
| Ionic impurities | | $Na^+$, $K^+$ and $Cl^-$ each being less than 1 ppm. | $Na^+$, $K^+$ and $Cl^-$ each being less than 1 ppm. |
| Storage stability | Viscosity immediately after the preparation | 3800 cps. | 4400 cps. |
| | After storage at 5℃ for 6 months | 3600 cps. | 4100 cps. |
| Heat resistance of polyimide film | | 400℃ or over | 400℃ or over |
| Adhesion to silicon wafer | | Good | Good |

The results of Table 1 reveal that the photosensitive polyimide precursors embodying the invention were substantially free of the ionic impurities, with good storage stability, and were able to provide polyimide films with a good heat resistance.

Example 3

The general procedure of Example 1 was repeated except that 0.5 g of 2,6-di(p-azido-benzal)4-methylcyclohexane was added to 70 g of a N-methyl-2-pyrrolidone solution of the polyimide precursor (A) obtained in the same manner as in Example 1, thereby obtaining a solution composition of the photosensitive polyimide precursor.

The thus obtained composition was spin coated on a silicon wafer by means of a spinner and dried at 80°C for 1 hour to obtain a 6 μm thick film. The film was exposed to light from a high pressure mercury lamp (500 W) through a mask for 25 seconds, followed by development with N-methyl-2-pyrrolidone and rinsing with isopropyl alcohol to obtain a clear resin pattern. This pattern was further thermally treated at 400°C for 30 minutes for conversion into a polyimide resin film.

The heat resistance of the thus obtained polyimide film was not lower than 400°C and the film had a good heat resistance. In addition, the adhesion to the silicon wafer was good.

Example 4

In the same manner as in Example 1, 4.4 g (0.02 mols) of pyromellitic dianhydride as the acid anhydride, 3.8 g (0.019 mols) of 4,4'-diaminodiphyl ether as the diamine, 0.24 g of 1,3-bis( δ-aminopropyl)-1,1,3,3-tetramethyldisiloxane, 60 g of N,N-dimethylacetamide as the solvent, and 3.8 g (0.02 mols) of the hydrosilane (ii) of the following structural formula used as the hydrosilane were used to obtain a N,N-dimethylacetamide solution of photosensitive polyimide precursor (B) of the following structure.

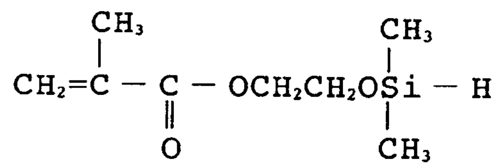

....(ii)

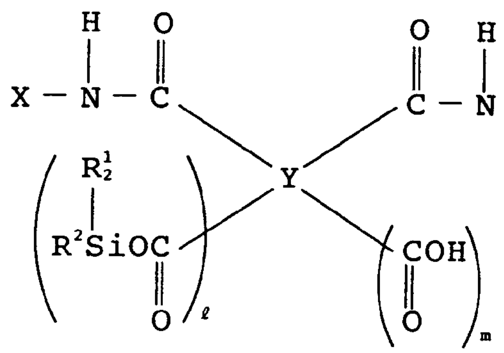

....(B)

X: 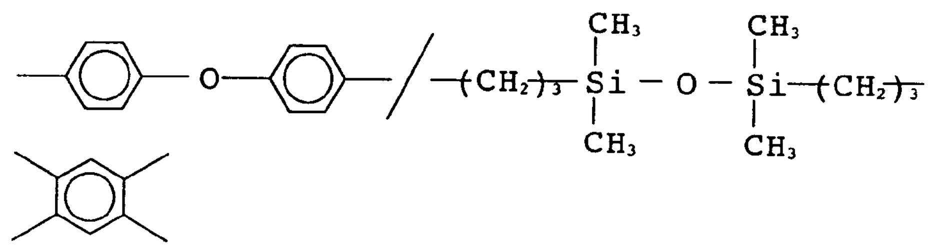 = 95/5

Y:

$R^1$: - $CH_3$ , $R^2$:

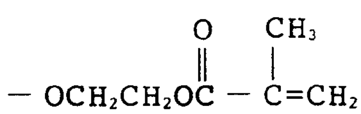

m /ℓ = 1

Thereafter, 1.0 g of ethyl thioxanthone was added to the solution and agitated, followed by filtration through a 1 μm filter to obtain a solution composition of the photosensitive polyimide precursor having a viscosity of 520 cps.

This solution composition had concentrations of ionic impurities of $Na^+$, $K^+$ and $Cl^-$ at a level as low as not higher than 1 ppm. The viscosity after storage at 5°C for 6 months was 480 cps., and thus, the variation in the viscosity was small with good storage stability.

The composition was spin coated on a silicon wafer by means of a spinner and dried at 80°C for 1 hour to obtain a 5 μm thick film. The film was exposed to light from a high pressure mercury (500 W) through a mask for 30 seconds. After the exposure, the film was developed with N-methyl-2-pyrrolidone and rinsed with isopropyl alcohol to obtain a clear resin pattern. The pattern was thermally treated at 150°C for 1 hour and then at 400°C for 30 minutes to convert to a polyimide resin film.

The heat resistance of the thus obtained polyimide film was 400°C or over and thus a good heat resistance was obtained. In addition, adhesion to the silicon wafer was good.

Example 5

In the same manner as in Example 1, there were used 5.3 g (0.018 mols) of 3,3′,4,4′-biphenyltetracarboxylic dianhydride used as the acid anhydride, 0.9 g (0.002 mols) of 1,3-bis(3,4-dicarboxyphenyl)-1,1,3,3-tetra-methyldisiloxane dianhydride, 4.0 g (0.02 mols) of 4,4′-diaminodiphenyl ether used as the diamine, 30 g of N-methyl-2-pyrrolidone as the solvent, 30 g of γ-butyrolactone, and 7.6 g (0.04 mols) of hydrosilane (ii), thereby obtaining a solution of a photosensitive polyimide precursor (C) having the following structure

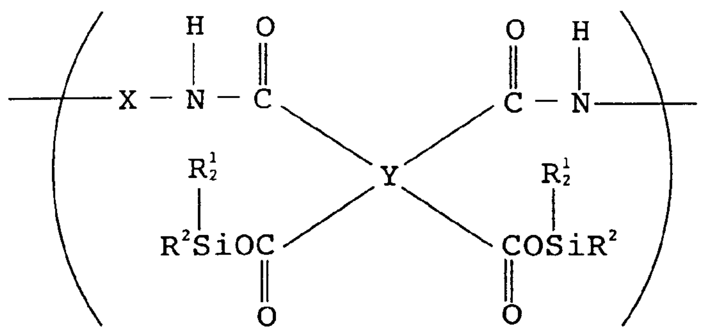

....(C)

X:

Y:

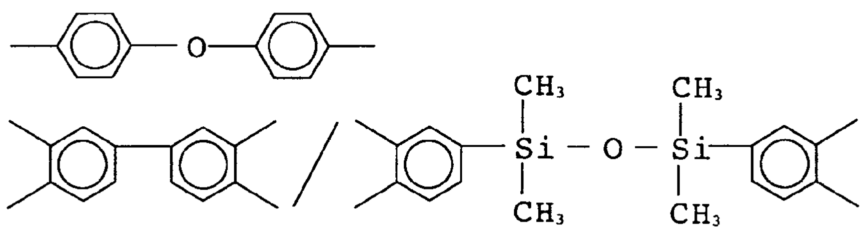

= 90/10

$R^1$: $-CH_3$ , $R^2$: 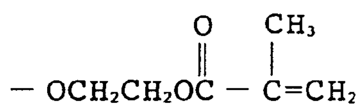

1.0 g of ethyl thioxanthone was added to the solution and agitated, followed by filtration through a 1 μm filter to obtain a solution composition of a photosensitive polyimide precursor having a viscosity of 8000 cps.

The solution composition had ionic impurities such as $Na^+$, $K^+$ and $Cl^-$ at levels as low as not higher than 1 ppm. After storage at 5°C for 6 months, the viscosity was 7700 cps., and was small in the variation with good storage stability.

The composition was spin coated on a silicon wafer by means of a spinner and dried at 80°C for 1 hour to obtain a 6 μm thick film. The film was exposed to light from a high pressure mercury lamp (500 W) through a mask for 20 seconds, followed by development with N-methyl-2-pyrrolidone and rinsing with isopropyl alcohol to obtain a clear resin pattern.

## Claims

1. A photosensitive material which comprises a photosensitive polyimide precursor having recurring units of the following general formula (1)

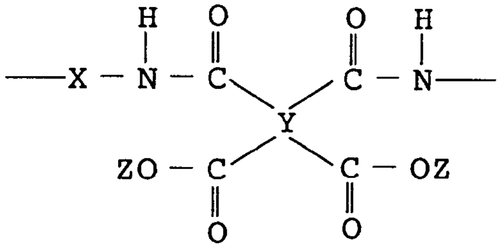

....(1)

wherein X represents a divalent organic group, Y represents a tetravalent organic group, and each Z represents a hydrogen atom or $SiR^1{}_nR^2{}_{(3-n)}$ provided that at least one Z is $SiR^1{}_nR^2{}_{(3-n)}$, in which $R^1$ is a group having a functional group capable of dimerization or polymerization by application of light or other radiation, $R^2$ is a hydrogen atom or a monovalent organic group having from 1 to 10 carbon atoms, and n is an integer

of from 1 to 3.

2. A photosensitive material according to Claim 1, wherein the number of recurring units is in the range of from 5 to 500.

3. A photosensitive material according to claim 1 or claim 2 which is in the form of a solution in a solvent for said precursor.

4. A photosensitive material according to Claim 3, wherein said photosensitive material comprises from 30 to 98 wt% of the solvent.

5. A photosensitive material of claim 3 or claim 4, further comprising a poor solvent.

6. A photosensitive material of any preceding claim,further comprising 0.1 to 20 wt% of a photo-polymerization initiator (based on said precursor).

7. A photosensitive material according to any one of the preceding claims, which has been thermally treated at 200 to 500°C for a time sufficient to cure the photosensitive material to obtain a cured polyimide film.

8. A process for preparing a photosensitive polyimide precursor which comprises reacting a polyimide precursor having recurring units of the following general formula (2)

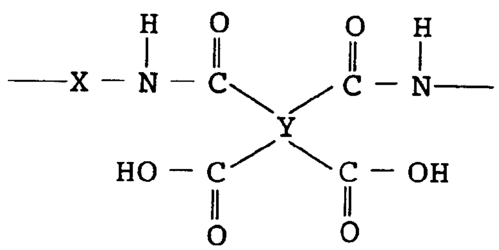

....(2)

wherein X is a divalent organic group and Y represents a tetravalent group, and a hydrosilane of the following general formula (3)

$$HSiR^1_nR^2_{(3-n)} \quad (3)$$

wherein $R^1$ is a group having a functional group capable of dimerization or polymerization by application of light or other radiation, $R^2$ is a hydrogen atom or a monovalent organic group having from 1 to 10 carbon atoms, and n is an integer of from 1 to 3, a ratio by weight between the hydrosilane and the carboxyl groups of said polyimide precursor being in the range of 0.1 : 1 to 1 : 1.

9. A process according to Claim 8, wherein said polyimide precursor having the recurring units of the formula (2) is obtained by reaction between a tetracarboxylic dianhydride and a diamine.

10. A process according to Claim 8 or 9, wherein the reaction is effected in an organic solvent capable of dissolving the dianhydride and the hydrosilane.

11. A process according to Claim 8, 9 or 10 wherein the reaction is effected in the presence of a catalyst at room temperature to 120°C.

12. Use of a material according to any one of claims 1 to 6 to form a coating film on a substrate.

13. Use according to claim 12, comprising forming a pattern by selectively irradiating the film and removing non-irradiated portions thereof.

14. Use according to claim 13, comprising baking the patterned film.

European Patent Office

# EUROPEAN SEARCH REPORT

Application Number

EP 92 30 3219

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | EP-A-0 436 457 (INTERNATIONAL BUSINESS MACHINES CORP.) * Page 9, lines 5-10; page 11, lines 10-16 * | 1-7,12-14 | G 03 F 7/075<br>G 03 F 7/038<br>C 08 G 73/10 |
| A | EP-A-0 157 930 (SIEMENS AG) * Page 5, lines 10-15; page 6, lines 6-9 * | 1-14 | |
| A | FR-A-2 126 428 (CIBA-GEIGY AG) * Page 2 * | 1-14 | |
| X | PATENT ABSTRACTS OF JAPAN, vol. 13, no. 215 (P-874)[3563], 19th May 1989; & JP-A-01 031 150 (TOA NENRYO KOGYO K.K.) 01-02-1989 * Abstract * | 1-5,7 | |

TECHNICAL FIELDS SEARCHED (Int. Cl.5)

G 03 F
C 08 G

The present search report has been drawn up for all claims

| Place of search | Date of completion of the search | Examiner |
|---|---|---|
| THE HAGUE | 24-06-1992 | DUPART J-M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)